# EUROPÄISCHE PATENTANMELDUNG

(11) **EP 1 542 324 A1**
(43) Veröffentlichungstag der Anmeldung: **15.06.2005**
(21) Anmeldenummer: 04028538.9
(22) Anmeldetag: 02.12.2004
(51) Int. Cl.: H02B 1/052, H02B 1/56

(54) **Lüftersystem für Stromverteileranlagen**

(30) Priorität: 12.12.2003 DE 10358136; 20.02.2004 DE 4008513
(71) Anmelder: Hager Electro GmbH, 66131 Saarbrücken (DE)
(72) Erfinder: Gros, Bernhard, F-57455 Seingbouse (FR)
(74) Vertreter: Bernhardt, Winfrid, Dr.-Ing.

(57) **Zusammenfassung**

Die Erfindung betrifft ein Lüftersystem für Stromverteileranlagen, mit wenigstens einem, innerhalb eines Verteilerschranks oder -kastens zu installierenden Lüfter. Gemäß der Erfindung weist der Lüfter ein zur Montage an einer Trägerschiene, insbesondere Hutprofilträgerschiene, vorbereitetes Gehäuse auf.

## Beschreibung

Die Erfindung betrifft ein Lüftersystem für Stromverteileranlagen, mit wenigstens einem, innerhalb eines Verteilerschranks oder -kastens zu installierenden Lüfter.

In Stromverteileranlagen wird ungewollt ein geringer Teil der zu verteilenden elektrischen Energie in Wärme umgesetzt. Insbesondere dann, wenn bei einer nachträglichen Erweiterung der Verteileranlage das Volumen des Schranks oder Kastens unterdimensioniert ist, kann es im Innern zu unzulässig hohen Temperaturen kommen. Es ist bekannt, der Temperaturerhöhung in Verteilerschränken durch installierte Lüfter zu begegnen, welche die Luft im Verteilerschrank umwälzen oder aus dem Schrank abführen und dadurch für eine verstärkte Wärmeabfuhr sorgen.

Der vorliegenden Erfindung liegt die Aufgabe zugrunde, ein neues Lüftersystem für Verteileranlagen zu schaffen, das sich mit geringem Aufwand installieren lässt.

Das diese Aufgabe lösende Lüftersystem nach der Erfindung ist dadurch gekennzeichnet, dass der Lüfter ein zur Montage an einer Trägerschiene vorbereitetes Gehäuse aufweist.

Vorteilhaft lässt sich gemäß der Erfindung ein Lüfter in Verteilerschränken oder -kästen in gleicher Weise wie die üblichen Einbaugeräte, insbesondere Leitungsschutzschalter, z.B. auf einer Hutprofilträgerschiene montieren, wobei der Lüfter ein Glied in einer Reihe solcher Einbaugeräte sein kann.

Für den Lüfter lässt sich das gleiche Normgehäuse wie für die Einbaugeräte verwenden. Wenigstens aber entspricht die Länge eines Lufteintrittsöffnungen aufweisenden Frontabschnitts des Lüftergehäuses in Längsrichtung der Trägerschiene einer genormten Rasterlänge A oder einem Mehrfachen davon. Ferner kann die Länge des Frontabschnittes in einer Richtung senkrecht zur Längsrichtung der Trägerschiene gleich der Höhe eines in einer Frontabdeckung des Verteilerschranks oder -kastens gebildeten Fensters sein, dessen horizontale Länge einem Vielfachen der Rasterlänge A entspricht.

Üblicherweise stehen in Verteileranlagen entsprechende Frontabschnitte von Einbaugeräten in das Fenster hinein vor, so dass Schalter betätigt werden können, ohne die Frontabdeckung abzunehmen. Anstelle eines Schalters oder anderen Gerätes kann in der Reihe von Einbaugeräten ein Lüfter angeordnet sein. Der nicht von Einbaugeräten oder dem Lüfter eingenommene Bereich des Fensters ist durch Abdeckplatten zu verschließen, die entsprechend der Rasterlänge A in unterschiedlichen Längen zur Verfügung stehen. Indem das Fenster durch die Geräte und die Abdeckung im übrigen verschlossen ist, lässt sich durch den Lüfter wirksam Luft aus dem Innenraum des Schranks bzw. Kastens ansaugen.

Der genannte Frontabschnitt kann mit Einrichtungen zur Verbindung mit einem Luftleitkanal versehen sein, z.B. einer umlaufenden Randabstufung, auf welche ein solcher Kanal aufsteckbar ist. Der Luftleitkanal lässt sich z.B. zu einer Öffnung in einer im Abstand zu der Frontabdeckung angeordneten Schranktür oder zu einer Seitenwand des Verteilerschranks oder -kastens führen.

Zweckmäßig weist der Lüfter einen Thermostatregler auf, so dass er erst bei Überschreiten einer vorgegebenen Temperaturgrenze wirksam wird. Zweckmäßig ist der Luftstrom des Lüfters umkehrbar, so dass z.B. an einem Verteilerschrank zwei Lüfter, vorzugsweise oben und unten, installiert werden können, von denen ein Lüfter Luft in den Schrank hinein ansaugt und der andere daraus absaugt.

Zur Erzeugung einer Lufteintrittsöffnung am Schrank oder Kasten könnte auch ein Leergehäuse eines Lüfters installiert werden.

In weiterer Ausgestaltung der Erfindung weist der Lüfter eine Warneinrichtung auf, die z.B. dann wirksam wird, wenn eine zulässige Temperatur, z.B. infolge Defekt des Lüfters, überschritten wird. Auch könnte die Funktion des Lüfters selbst überwacht werden, wobei auch an eine Fernübertragung eines Schaltsignals zu denken ist.

Für den Lüfter kommen sowohl Axiallüfterräder als auch Radiallüfterräder in Betracht. Bei Verwendung eines Radiallüfterrades beträgt die Länge des Gehäuses in Längsrichtung der Schiene zweckmäßig zwei oder mehr Rasterlängen. Ein Axiallüfterrad kann schräg zu den Wänden eines flachen Lüftergehäuses eingebaut werden, um durch Verbesserung der Strömungsverhältnisse den Luftdurchsatz zu erhöhen.

In weiterer Ausgestaltung der Erfindung kann der Lüfter mit einem zur Montage auf der Trägerschiene vorgesehenen Einbaugerät, z.B. einem Leitungsschalter, Fehlerstromschalter, Relais, Schütz, Dimmer u. dgl. kombiniert sein.

Der Lüfter lässt sich z.B. in einem mit dem Einbaugerät gemeinsamen Gehäuse unterbringen, wobei die Gehäuselänge in Richtung der Trägerschiene doppelt so groß wie die betreffende Länge für solche Einbaugeräte sonst verwendeter Normgehäuse sein kann.

Die Kombination des Lüfters mit einem Peltierkühlelement wäre denkbar.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: einen zur Montage auf einer Hutprofilschiene vorgesehen Lüfter nach der Erfindung,
- Fig. 2: einen Verteilerkasten, in den ein Lüfter nach der Erfindung eingebaut ist,
- Fig. 3: ein weiteres Ausführungsbeispiel für einen Lüfter nach der Erfindung,
- Fig. 4: einen Querschnitt durch einen Verteilerkasten, in den ein Lüfter gemäß Fig. 2 eingebaut ist, und
- Fig. 5: einen weiteren Querschnitt durch einen Verteilerkasten mit eingebautem Lüfter gemäß Fig. 2.

Ein Lüftergehäuse 1 weist einen gegenüber der Länge des übrigen Gehäuses verkürzten Frontabschnitt 2 und Elemente 3 und 4 auf der Rückseite zur Montage des Gehäuses auf einer bei 5 angedeuteten Hutprofilschiene auf. An der Vorderseite des vorspringenden Frontabschnitts 2 sind Luftdurchtrittsöffnungen 6 gebildet. Weitere schlitzförmige Luftdurchtrittsöffnungen 7 befinden sich an einer Seite des Gehäuses, welche im montierten Zustand des Lüfters in einem Verteilerschrank oder -kasten die Unterseite des Lüfters bildet.

Das Gehäuse weist eine einheitliche horizontale Länge auf. Diese Länge entspricht einem genormten Rastermaß A für in Verteilereinrichtungen einzubauende Modulargeräte, insbesondere Sicherungsschalter. Auch bei der vertikalen Länge B des vorspringenden Frontabschnitts handelt es sich um ein Normmaß.

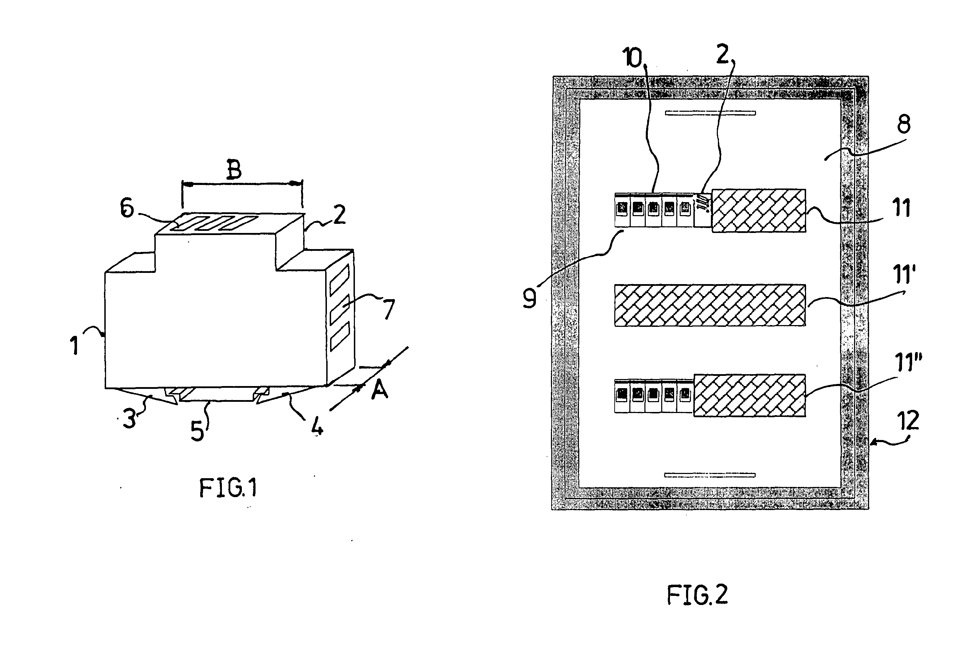

Fig. 2 zeigt einen Verteilerkasten 12 mit einer Frontabdeckung 8, in der, in dem gezeigten Beispiel, drei Fenster 9 gebildet sind. Die horizontale Länge der Fenster 9 beträgt ein Vielfaches des Rastermaßes A, die Fensterhöhe ist gleich der Länge B des vorspringenden Frontabschnitts 2.

Hinter dem obersten der drei Fenster 9 sind in den Verteilerkasten Modulargeräte in Form von Sicherungsschaltern 10 sowie ein Lüfter gemäß Fig. 1 eingebaut. Der Frontabschnitt 2 des Lüfters steht zusammen mit entsprechenden Frontabschnitten der Sicherungsschalter 10 in das Fenster 9 hinein vor. Die Sicherungsschalter und der Lüfter sind innerhalb des Verteilerkastens auf einer gemeinsamen Hutschiene (nicht sichtbar) montiert. Auch die Sicherungsschalter weisen das Rastermaß A auf.

Ein durch die Sicherungsschalter und den Lüfter nicht verschlossener Teil des Fensters 9 ist durch eine Platte 11 abgedeckt. Abdeckplatten, wie weitere gezeigte Platten 11' und 11 ", stehen in verschiedenen Längen zur Verfügung, wobei die Längendifferenz gleich dem Rastermaß A oder einem Vielfachen davon ist.

Der in den Kasten gemäß Fig. 2 eingebaute Lüfter saugt aus dem Kasteninnenraum, in dem ungewollt elektrische Energie in Wärme umgesetzt wird, warme Luft durch die Luftdurchtrittsöffnungen 7 hindurch an und befördert sie durch die Öffnungen 6 nach außen. Kalte Luft kann durch die nicht absolut dichten Fenster 9 oder weitere Schlitze und Spalte in den Kasten eintreten. Durch ein Leergehäuse eines Lüfters ließe sich eine gesonderte Eintrittsöffnung bilden.

Der Lüfter ist mit einer Thermostatsteuerung versehen, durch die er in Betrieb gesetzt wird, wenn die Innentemperatur im Verteilerkasten einen bestimmten Wert erreicht, und die den Lüfter ausschaltet, wenn ein unterer Temperaturgrenzwert erreicht ist.

Um einen stärkeren Luftdurchsatz und eine noch wirksamere Kühlung zu erreichen, könnte in dem untersten Fenster ein weiterer Lüfter vorgesehen sein, dessen Lüfterrad umgekehrt läuft, d.h. der über seine Luftdurchtrittsöffnungen 6 Luft ansaugt und durch die Luftdurchtrittsöffnungen 7 hindurch ausstößt.

Der Lüfter könnte ferner mit einer Überwachungseinrichtung versehen sein, welche bei zu hoher Temperatur im Verteilerkasten, z.B. wegen eines Lüfterdefekts, ein ggf. fernübertragbares Schaltsignal erzeugt, das einen Leistungsschalter aktiviert, welcher die Stromzufuhr zur Verteileranlage unterbricht.

In den weiteren Figuren sind gleiche oder gleichwirkende Teile mit derselben Bezugszahl wie in Fig. 1 und 2 bezeichnet, wobei der betreffenden Bezugszahl jeweils der Buchstabe a, b bzw. c beigefügt ist.

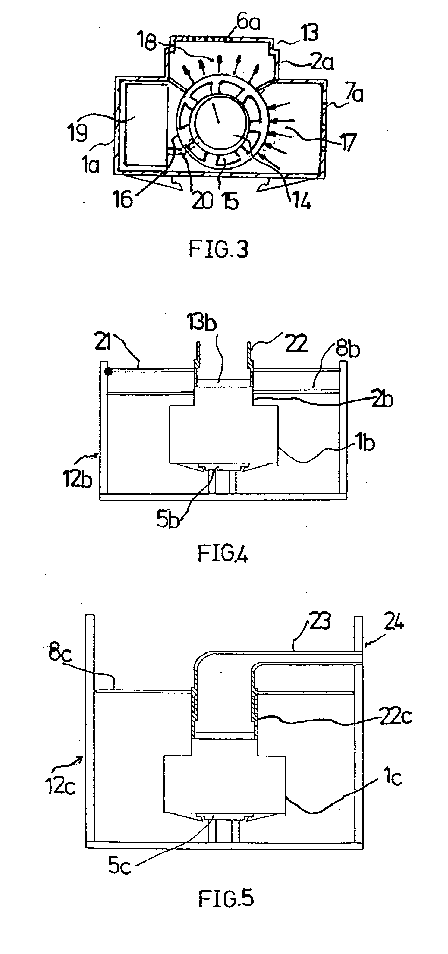

Fig. 3 zeigt einen halb offenen Lüfter mit einem Kunststoffgehäuse 1 a. Ein vorstehender Frontabschnitt 2a weist im Unterschied zu dem Lüfter von Fig. 1 und 2 eine umlaufende Randabstufung 13 auf.

Ein im Inneren des Gehäuses angeordneter Antriebsmotor 14 treibt ein Axiallüfterrad 15 an, das von einem ringförmigen Luftleitgehäuse 16 umgeben ist. Bei 17 wird durch Öffnungen 7a in das Gehäuse 1 a eintretende Luft durch eine nicht sichtbare Öffnung hindurch in das Luftleitgehäuse 16 eingesaugt und tritt bei 18 aus dem Luftleitgehäuse aus. Es versteht sich, dass in der in Fig. 2 gezeigten Draufsicht gesehen, die Öffnung für die eintretende Luft unterhalb und die Öffnung für die austretende Luft oberhalb des Axiallüfterrades oder umgekehrt angeordnet sind. Um Öffnungen großer Weite bilden zu können, kann das Axiallüfterrad schräg in das Gehäuse eingebaut sein.

Das Bezugszeichen 19 weist auf ein Netzteil hin, das Wechselspannung bis zu 230 Volt auf eine zum Betrieb des Motors 14 geeignete Spannung transformiert, welche über Leitungen 20 an den Motor 14 angelegt wird.

Fig. 4 zeigt einen Verteilerkasten 12b, der neben einer Frontabdeckung 8b eine im Abstand zur Frontabdeckung angeordnete Schranktür 21 aufweist.

Innerhalb des Verteilerkastens 12b ist ein Lüfter mit einem Gehäuse 1 b angeordnet, dessen Frontabschnitt 2b durch ein Fenster in einer Abdeckung 8b geführt ist. Durch ein auf eine Randabstufung 13b des Frontabschnitts 2b aufgesteckter Luftleitkanal 22 hindurch wird aus dem Kasteninnern angesaugte Luft nach außen abgeführt, wobei der Luftleitkanal durch eine Öffnung in der Schranktür 21 ragt.

Fig. 5 zeigt einen Verteilerkasten 12c, in dem ein dem Lüfter von Fig. 3 und 4 gleicher Lüfter mit einem Gehäuse 1 c auf einer Hutprofilschiene 5c montiert ist. Zu einer im Abstand von dem Lüfter vorgesehenen Frontabdeckung 8c ist ein Luftleitkanal 22c geführt und in den Luftleitkanal 22c ist ein weiterer, abgewinkelter Luftleitkanal 23 eingesteckt, wobei der Luftleitkanal 23 an einer Öffnung 24 in einer Seitenwand des Verteilerkastens 12c endet.

Ein dem Luftleitkanal 22c entsprechendes Luftleitkanal könnte einstückig an eine Frontabdeckung angeformt sein.

## Patentansprüche

1. Lüftersystem für Stromverteileranlagen, mit wenigstens einem, innerhalb eines Verteilerschranks oder -kastens zu installierenden Lüfter,
**dadurch gekennzeichnet, dass** der Lüfter ein zur Montage an einer Trägerschiene (5) vorbereitetes Gehäuse (1) aufweist.

2. Lüftersystem nach Anspruch 1,
**dadurch gekennzeichnet,**
**dass** das Lüftergehäuse zur Montage auf einer Hutprofilträgerschiene (5) vorbereitet ist.

3. Lüftersystem nach Anspruch 1 oder 2,
**dadurch gekennzeichnet,**
**dass** wenigstens die Länge eines Lüfteraustrittsöffnungen (6) aufweisenden Frontabschnitts (2) des Lüftergehäuses (1) in Längsrichtung der Trägerschiene (5) einer Rasterlänge (A) oder einem Mehrfachen davon entspricht.

4. Lüftersystem nach Anspruch 3,
**dadurch gekennzeichnet,**
**dass** die Länge (B) des Frontabschnittes (2) in einer Richtung senkrecht zur Längsrichtung der Trägerschiene (5) gleich der Höhe eines in einer Frontabdeckung (8) des Verteilerschranks oder -kastens (12) gebildeten Fensters (9) ist.

5. Lüftersystem nach Anspruch 4,
**dadurch gekennzeichnet,**
**dass** die horizontale Länge des Fensters (9) einem Vielfachen der Rasterlänge (A) entspricht.

6. Lüftersystem nach einem der Ansprüche 1 bis 4,
**dadurch gekennzeichnet,**
**dass** der Lüfter einen Thermostatregler aufweist.

7. Lüftersystem nach einem der Ansprüche 1 bis 6,
**dadurch gekennzeichnet,**
**dass** die Luftstromrichtung des Lüfters umkehrbar ist.

8. Lüftersystem nach einem der Ansprüche 3 bis 7,
**dadurch gekennzeichnet,**
**dass** der Frontabschnitt (2a) Einrichtungen (13) zur Verbindung mit einem Luftleitkanal (22,23) aufweist.

9. Lüftersystem nach Anspruch 8,
**dadurch gekennzeichnet,**
**dass** der Luftleitkanal in eine Wand des Verteilerschranks oder/und -kastens integriert ist.

10. Lüftersystem nach einem der Ansprüche 1 bis 9,
**dadurch gekennzeichnet,**
**dass** der Lüfter zur Erzeugung eines, ggf. fernübertragbaren, Schaltsignals vorgesehen ist.

11. Lüftersystem nach einem der Ansprüche 1 bis 10,
**dadurch gekennzeichnet,**
**dass** der Lüfter mit einem zur Montage auf der Trägerschiene (5) vorgesehenen Einbaugerät kombiniert ist.
